# EUROPÄISCHE PATENTSCHRIFT

(11) **EP 2 006 916 B1**
(45) Veröffentlichungstag und Bekanntmachung des Hinweises auf die Patenterteilung: **23.05.2012**
(21) Anmeldenummer: 08010794.9
(22) Anmeldetag: 13.06.2008
(51) Int. Cl.: H01L 31/042, H01L 31/048

(54) **Photovoltaik-Anordnung**
Photovoltaic unit
Dispositif photovoltaïque

(30) Priorität: 18.06.2007 DE 102007028447
(43) Veröffentlichungstag der Anmeldung: 24.12.2008
(73) Patentinhaber: Baumgartner, Siegfried, 77971 Kippenheim (DE)
(72) Erfinder: Baumgartner, Siegfried, 77971 Kippenheim (DE)
(74) Vertreter: Maucher, Wolfgang

(56) Entgegenhaltungen:
- JP-A- 9 069 645
- US-A- 4 025 786
- US-B1- 6 515 217

## Beschreibung

Photovoltalk-Anordnung mit einem Solarmodul, welches eine Trägerschicht und darauf befindliche Photovoltaik-Zellen aufweist, die über Leiterbahnen elektrisch miteinander verbunden sind, wobei das Solarmodul, zumindest bereichsweise, über Zwischenräume beabstandete Photovoltaik-Zellen aufweist und das Solarmodul mehrere Trägerschichten mit darauf befindlichen Photovoltaik-Zellen aufweist, von denen jeweils zumindest einige Zellen Abstand zueinander haben, und wobei die Trägerschichten übereinander angeordnet und galvanisch voneinander getrennt sind. Daneben betrifft die Erfindung auch eine Verwendung einer solchen Photovoltaik-Anordnung.

Photovoltaik-Anordnungen mit Solarmodulen, wie sie beispielsweise aus der DE 103 49 269 A1 bekannt sind, wurden seit geraumer Zeit zur Energiegewinnung insbesondere an Gebäudedächern eingesetzt. Photovoltaik-Anordnungen, welche Solarmodule mit mehreren Trägerschichten mit darauf befindlichen Photovoltaik-Zellen aufweisen und bei denen beabstandete Zellen vorkommen, die so gegeneinander versetzt sind, dass eine energetisch optimale Ausnutzung der von der Sonne als Lichtquelle bestrahlten Fläche erreicht wird, sind der JP-A- 09069645 und der US-A-4025786 zu entnehmen.

In jüngerer Vergangenheit ist zunehmend auch ein Interesse hinsichtlich der Verwendung solcher Module an Fassaden- oder Fensterflächen zu beobachten, um auf diese Weise den dort zur Verfügung stehenden Platz an Gebäuden entsprechend nutzen zu können. Da die bisher nach technischen Gesichtspunkten gestalteten Photovoltaik-Anordnungen aber keinen besonders ansprechenden optischen Eindruck machen, wurde bisher weitgehend auf eine Anbringung von Photovoltaik-Anordnungen an Fassadenflächen verzichtet. Es sind also bei diesen Flächen, im Gegensatz zu Dachflächen, durchaus gestiegene Anforderungen an Design und Optik der jeweiligen Photovoltaik-Anordnungen bei möglichst unverändert hohem Wirkungsgrad festzustellen.

Es besteht daher die Aufgabe, eine einfach herzustellende Photovoltaik-Anordnung zur Verfügung zu stellen, die gut handhabbar und elektrisch sicher sowie einfach zu verschalten ist, und dem Anwender den Einsatz der Anordnung zur optischen Gestaltung einer Gebäudefläche gestattet.

Diese zunächst scheinbar widersprüchliche Aufgabe wird gelöst durch eine Photovoltaik-Anordnung der eingangs genannten Art, bei welcher die Photovoltaik-Zellen der einzelnen, übereinander befindlichen Trägerschichten derart gegeneinander seitlich versetzt sind, dass sie einen oder mehrere Zwischenräume zwischen den Zellen einer anderen Schicht überdecken und mehrere oder wenigstens ein Zwischenraum zwischen den Zellen zumindest teilweise derart überdeckungsfrei ist, dass ein Anteil des von einer Lichtquelle auf die Photovoltaik-Anordnung eingestrahlten Lichts das Solarmodul durchtritt.

Durch die Erfindung ist damit nun ein Einsatz der betreffenden Anordnungen auch als architektonisches Stilmittel an einer Fassade möglich. Dieser Einsatz war zuvor insoweit gewissermaßen technisch bedingt begrenzt, als sich Solarmodule wirtschaftlich in aller Regel nur als jeweils lineare Kette benachbarter oder beabstandeter Photovoltaik-Zellen mit diese verknüpfenden Leiterbahnen fertigen lassen, und derart immer ein möglichst vollflächig belegtes Solarmodul angestrebt wurde. Ein beispielsweise zugunsten einer bestimmten Lichtdurchlässigkeit gewünschtes Gittermuster würde hierbei zu sich kreuzenden Leiterbahnen führen, die elektrisch aufgrund möglicher Überschläge ein Risiko darstellen. Überdies können die der Verschaltung dienenden Leiterbahnen, wenn sie zwischen beabstandeten Zellen freiliegen, ein unerwünschtes optisches Element darstellen, das es zu verbergen gilt.

Bei dem betreffenden Solarmodul der Photovoltaik-Anordnung sind die einzelnen Trägerschichten aufgrund des erwünschten optischen Eindrucks nicht vollflächig mit Photovoltaik-Zellen versehen, da sich ansonsten, wie bereits erwähnt, eine einheitliche, in der Regel dunkle Bedeckung der bedeckten Fläche ergäbe. Vielmehr sind die an den Trägerschichten angeordneten Photovoltaik-Zellen durch Zwischenräume beabstandet, was einerseits eine musterhafte Gestaltung der Trägerschichten bzw. von deren Projektion und andererseits auch eine gewisse Transparenz der Schichten hinsichtlich eines gewünschten Lichteinfalls auf die dahinter liegende Fläche bzw. den dahinter befindlichen Raum gestattet. Durch die ebene, sandwichartige Anordnung wenigstens zweier Schichten von Photovoltaik-Zellen hintereinander, lässt sich aus einer im Prinzip beliebigen Palette von Grundmustern von Photovoltaik-Zellen in jeweils einer, einfach herzustellenden Schicht ein gewünschter optischer Eindruck der Scheibe für den Betrachter durch Überlagerung konstruieren. Gleichzeitig ist die entstehende Scheibe aber auch elektrisch sicher, da die betreffenden, fertigungstechnisch einfach herzustellenden Schichten, die auch Layer genannt werden, durch die galvanische Trennung keinerlei Kontakt zueinander aufweisen und es derart nicht zu sich kreuzenden Leiterbahnen kommt. Die Photovoltaik-Zellen können hierbei prinzipiell in jedem zur Fertigung der Layer geeigneten Verfahren hergestellt sein und dann verschieden Ausbildungen aufweisen, beispielsweise als mono- oder polykristalline Zellen. Im Sinne einer einfach zu haltenden Herstellung der Trägerschichten bzw. des Solarmoduls kann es bei der Anordnung der Trägerschichten auch vorgesehen sein, dass ein oder mehrere Photovoltaik-Zellen einer Schicht Photovoltaik-Zellen einer anderen Schicht zumindest teilweise abschatten oder überdecken, so dass der Wirkungsgrad einzelner Zellen eingeschränkt sein kann. Ebenso können die Zellen einer Schicht derart kleiner als die einer anderen ausgebildet sein, dass zwischen den Photovoltaik-Zellen freie Zwischenräume verbleiben und die Zellen einer Schicht zu denen einer anderen allseits beabstandet sind.

Eine sinnvolle Weiterbildung der erfindungsgemäßen Photovoltaik-Anordnung, die die Gestaltungsmöglichkeiten erweitert, kann darin bestehen, dass das Solarmodul drei oder mehr Trägerschichten mit Photovoltaik-Zellen aufweist.

Eine optisch ansprechende Gestaltung einer Photovoltaik-Anordnung mit Solarmodul kann mit einer anderen Ausbildung der Erfindung erreicht werden, bei der die Anordnung derart vorgesehen ist, dass in Zellenzwischenräumen einer Trägerschicht verlaufende Leiterbahnen durch Photovoltaik-Zellen zumindest einer weiteren Trägerschicht überdeckt sind. Auf diese Weise sind die Leiterbahnen für eine Betrachter der Anordnung an einer Fassade praktisch unsichtbar.

Besonders einfach zu fertigende Photovoltaik-Anordnungen, die bereits gute Gestaltungsmöglichkeiten bieten, können schon mit zwei Trägerschichten von Photovoltaik-Zellen erreicht werden, so dass eine Weiterbildung der Erfindung darin bestehen kann, dass das Solarmodul zwei Trägerschichten aufweist, von welchen die erste mit zueinander beabstandeten Reihen, jeweils bestehend aus unmittelbar benachbarten Photovoltaik-Zellen, versehen ist, während die zweite Trägerschicht einzelne, mit Zwischenräumen beabstandete Photovoltaik-Zellen aufweist. Ein Zusammenfügen der betreffenden Trägerschichten an dem Solarmodul ergibt dann ein Reihenmuster, bei welchem die Zwischenräume zwischen Photovoltaik-Zellen der zweiten Trägerschicht an bestimmten Stellen mit Reihen von Photovoltaik-Zellen der ersten Trägerschicht überdeckt sind.

Eine zweckmäßige, weil einfach zu verschaltende Anordnung von Photovoltaik-Zellen der Trägerschichten kann bei einer bevorzugten Weiterbildung der erfindungsgemäßen Photovoltaik-Anordnung erreicht werden, indem die erste Trägerschicht entlang der Längserstreckung ihrer Reihen von Photovoltaik-Zellen mit Leiterbahnen verschaltet ist und mehrere jeweils benachbarte Photovoltaik-Zellen der zweiten Trägerschicht derart durch parallele Züge von Leiterbahnen verbunden sind, dass hierdurch reihenartige Bereiche von verschalteten und verschaltungsfreien Zwischenräumen zwischen diesen Photovoltaik-Zellen gebildet sind.

Besonders bevorzugt ist hierbei eine Weiterbildung der Photovoltaik-Anordnung, bei der die Photovoltaik-Zellen der ersten und der zweiten Trägerschicht derart gegeneinander seitlich versetzt angeordnet sind, dass die verschalteten reihenartigen Bereiche der zweiten Trägerschicht von Photovoltaik-Zellen der ersten Trägerschicht überdeckt sind. Übereinander angeordnet überdecken die Reihen von Photovoltaik-Zellen der ersten Trägerschicht also, neben anderen Zwischenräumen, jedenfalls alle Zwischenräume der zweiten Trägerschicht, an denen Leiterbahnen der elektrischen Verschaltung sichtbar sind. Der Verlauf der Leiterbahnen der beiden Trägerschichten ist demnach im wesentlichen rechtwinklig zueinander.

Besonders eindrucksvolle Effekte lassen sich mit Photovoltaik-Anordnungen erzeugen, die dem Betrachter eine gewisse optische Strukturierung der von ihnen bedeckten Fläche vermitteln, so dass bei einer bevorzugten Ausbildung der Erfindung die Photovoltaik-Zellen der übereinander angeordneten Trägerschichten des Solarmoduls ein gegebenenfalls regelmäßiges Muster, insbesondere ein Gittermuster, beispielsweise ein Netz- oder ein Schachbrettmuster, bilden.

Solche durch die Photovoltaik-Zellen erzeugten Muster sind vorteilhaft einfach zu erzeugen, wenn das Muster von Photovoltaik-Zellen des Solarmoduls aus rechteckigen, insbesondere quadratischen, und/oder rautenförmigen Photovoltaik-Zellen vorgesehen ist.

Besonders einfach in Herstellung und Anordnung der betreffenden Trägerschichten ist eine Photovoltaik-Anordnung bei der alle Photovoltaik-Zellen der Trägerschichten dieselbe Größe aufweisen.

Häufig ist es beim Einsatz von Photovoltaik-Anordnungen erwünscht, dass nicht alles einfallende Licht von der hinter der Photovoltaik-Anordnung liegenden Fläche bzw. dem dahinter befindlichen Raum ferngehalten wird, so dass bei einer Ausführung der Photovoltaik-Anordnung zweckmäßigerweise das Solarmodul mit den auf Trägerschichten befindlichen Photovoltaik-Zellen eine Lichtdurchlässigkeit in einem Bereich zwischen 10 und 90 Prozent, bevorzugt etwa zwischen 30 und 60 Prozent aufweist. Kommt es auf die Lichtdurchlässigkeit nicht an, kann die Photovoltaik-Anordnung beispielsweise auch auf einem lichtundurchlässigen Träger angebracht werden, der wiederum weitere Gestaltungsmöglichkeiten bieten kann.

Bei einer auch von den örtlichen Gegebenheiten des jeweiligen Gebäudes und den Benutzerwünschen abhängigen Anbringung einer Photovoltaik-Anordnung können an den von dieser bedeckten Fläche insbesondere Randbereiche auftreten, die sich einer Verschaltung der Photovoltaik-Zellen durch die Formgebung des Randbereichs entweder ganz entziehen oder bei Verschaltung der entsprechenden Zellen unerwünscht eine Reduktion der Spannung des Solarmoduls an sich aufträte, so dass es bei einer zweckmäßigen Weiterbildung der Photovoltaik-Anordnung vorgesehen ist, dass in Randbereichen des Solarmoduls befindliche Photovoltaik-Zellen einer oder mehrerer der Trägerschichten, insbesondere bei nicht rechteckiger Ausbildung der Photovoltaik-Anordnung, entweder elektrisch inaktivierbar oder nicht verschaltet sind. Dies kann insbesondere auch dann notwendig werden, wenn zur Anpassung von Randbereichen der Photovoltaik-Anordnung bzw. des Solarmoduls an örtliche Gegebenheiten die Trägerschichten und dann mit ihnen Photovoltaik-Zellen geschnitten werden müssen.

Eine gute Handhabbarkeit in Herstellung und Einsatz der erfindungsgemäßen Photovoltaik-Anordnung wir mit einer dünnen, die zwei oder mehr Trägerschichten von Photovoltaik-Zellen jeweils voneinander trennenden und isolierenden Zwischenschicht erreicht, weswegen bei einer Ausbildung der Photovoltaik-Anordnung das Solarmodul zwischen seinen Trägerschichten jeweils eine lichtdurchlässige Trennschicht, insbesondere ein Laminat oder eine dünne Scheibe aus Glas oder Kunststoff, aufweist, die die Trägerschichten gegeneinander elektrisch isoliert.

Eine einfache Anbringung einer Photovoltaik-Anordnung an der jeweils gewünschten Fläche, etwa einer Fassade, sowie ein Schutz gegen Feuchtigkeit, Temperatur und dergleichen Witterungseinflüsse kann bei einer weiteren Ausführungsform der Photovoltaik-Anordnung sichergestellt werden, bei der das Solarmodul zwischen zwei Tragelementen angeordnet ist, von welchen zumindest das der Lichtseite zugewandte Tragelement licht- bzw. strahlungsdurchlässig ist. Dabei können die Tragelemente beispielsweise beide als Glasscheiben ausgebildet sein oder das eine als Glasscheibe, das andere Tragelement als Folie.

Die Photovoltaik-Zellen bzw. die Trägerschichten können zwischen den sie einfassenden Tragelementen aus Gläsern und/oder Folien besonders einfach ortsfest fixiert werden, wenn die Schichten von Photovoltaik-Zellen durch ein zusätzliches Haltemittel, insbesondere ein Gießharz oder ein Laminat, zwischen den Tragelementen gehalten sind. Die Folie kann beispielsweise eine laminierte, UV-beständige Folie sein, die dem Harz gegenüber chemisch inert ist und mit diversen weiteren Beschichtungen, etwa als Farbfilm oder Metalldampf zum Erzielen besonderer Effekte, versehen werden kann.

Da an Gebäudeglasflächen häufig besondere Anforderungen, beispielsweise hinsichtlich Schlagfestigkeit, Witterungs- und Temperaturbeständigkeit, gestellt werden, besteht eine zweckmäßige Ausbildung der Photovoltaik-Anordnung darin, die Tragelemente aus Kunststoff- und/oder Glasscheiben, insbesondere aus Sicherheitsglas, vorzusehen, so dass sich die Trägerschichten von Photovoltaik-Zellen dann hinter einer sie schützenden, dem einfallenden Licht zugewandten Glasscheibe, insbesondere aus Einscheibensicherheitsglas oder Verbundsicherheitsglas, befinden.

Eine zweckmäßige Weiterbildung der erfindungsgemäßen Photovoltaik-Anordnung kann schließlich darin bestehen, dass das Solarmodul zum Einbau in eine Isolierverglasung vorgesehen ist, welche zum Beispiel zum Wärmeschutz, zur Schallisolierung oder zum Sonnenschutz einsetzbar ist.

Besonders vorteilhaft lässt sich die vorstehend beschriebene Photovoltaik-Anordnung als Fassaden-, Fenster- oder Dachelement eines mit optischen Effekten zu versehenden Gebäudes einsetzen.

Die Erfindung wird nachstehend anhand eines Ausführungsbeispiels in den Figuren der Zeichnung näher erläutert. In teilweise stark schematisierter Form zeigen dabei die
- Fig.1: eine Aufsicht eines Ausschnitts eines Solarmo- duls mit Trägerschichten von Photovoltaik- Zellen einer erfindungsgemäßen Photovoltaik- Anordnung;
- Fig.2: eine Aufsicht eines Ausschnitts einer ersten Trägerschicht von Photovoltaik-Zellen des So- larmoduls;
- Fig.3: eine Aufsicht eines Ausschnitts einer weiteren Trägerschicht von Photovoltaik-Zellen des So- larmoduls; und die
- Fig.4: eine Querschnittsansicht eines Ausschnitts ei- ner zwischen Glasscheiben angeordneten Photo- voltaik-Anordnung.

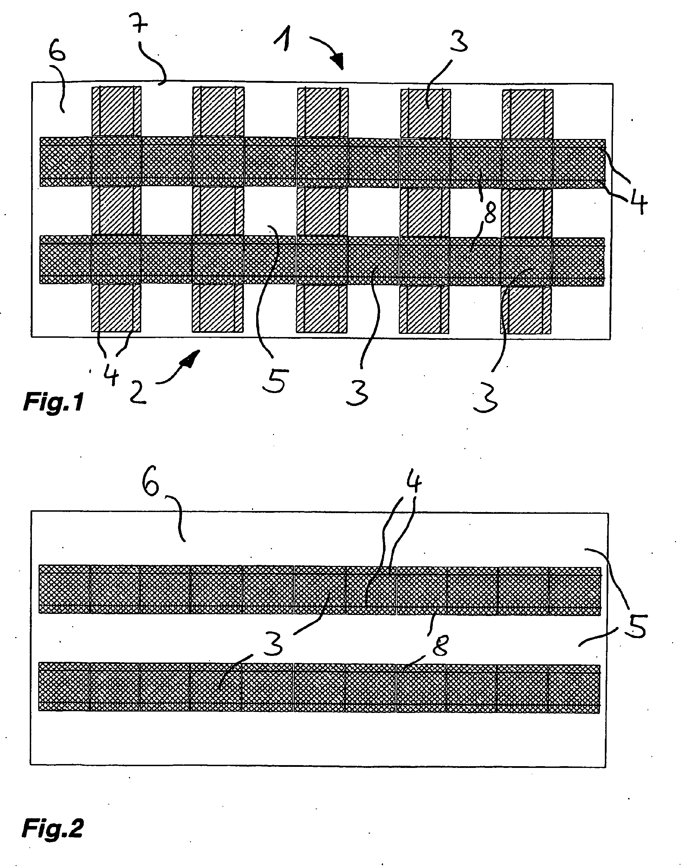

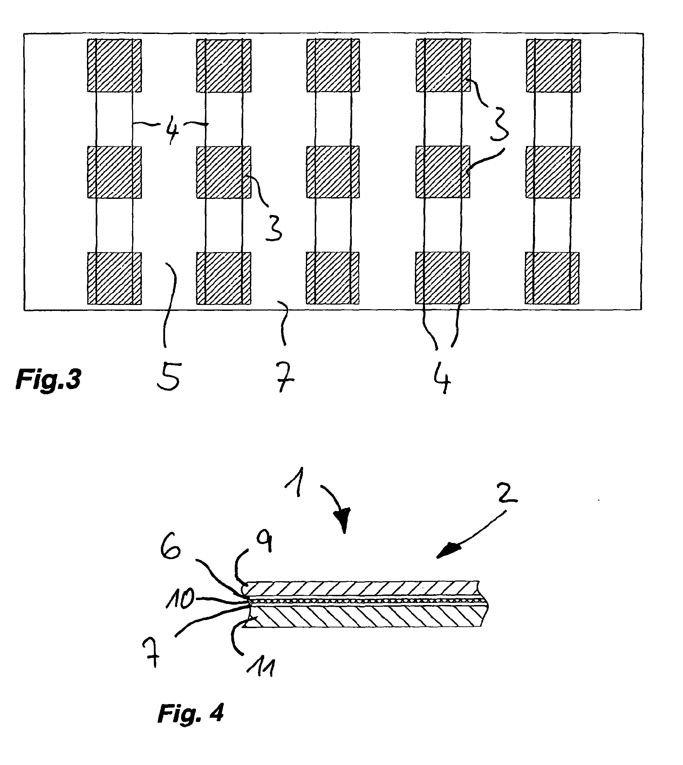

In der Fig.1 ist ein Ausschnitt einer im Ganzen mit 1 bezeichneten Photovoltaik-Anordnung mit einem Solarmodul 2 zu erkennen, wobei sich das Solarmodul 2. Photovoltaik-Zellen 3, die durch Leiterbahnen 4 miteinander verbunden sind, aufweist. In verschiedenen Bereichen des Solarmoduls 2 befinden sich über Zwischenräume 5 beabstandete Photovoltaik-Zellen 3. Das Solarmodul 2 weist dabei zwei Trägerschichten 6, 7 mit darauf befindlichen Photovoltaik-Zellen 3 auf, von denen jeweils zumindest einige Zellen 3 Abstand zueinander haben (Fig.2 und 3). Die Trägerschichten 6, 7 sind in dem Solarmodul der Fig.1 übereinander angeordnet und galvanisch voneinander getrennt. Die Photovoltaik-Zellen 3 der einzelnen, übereinander befindlichen Trägerschichten 6, 7 sind dabei derart gegeneinander seitlich versetzt, dass sie mehrere Zwischenräume 5 zwischen den Zellen 3 der anderen Schicht überdecken und mehrere Zwischenräume 5 zwischen den Zellen 3 derart überdeckungsfrei sind, dass ein Anteil des von einer nicht weiter dargestellten Lichtquelle auf die Photovoltaik-Anordnung 1 eingestrahlten Lichts das Solarmodul 2 durchtritt.

Bei dem, wie bereits erwähnt, mit zwei Trägerschichten 6, 7 versehenen Solarmodul 2 weist die erste Trägerschicht 6 (Fig.2) Reihen 8 unmittelbar benachbarter Photovoltaik-Zellen auf, während die zweite Trägerschicht 7 (Fig.3) einzelne, mit Zwischenräumen 5 beabstandete Photovoltaik-Zellen 3 aufweist.

Die erste Trägerschicht 6 des Solarmoduls 2 ist entlang der Längserstreckung ihrer Reihen 8 von Photovoltaik-Zellen 3 mit Leiterbahnen 4 verschaltet, wobei mehrere jeweils benachbarte Photovoltaik-Zellen 3 der zweiten Trägerschicht 7 derart durch parallele Züge von Leiterbahnen 4 verbunden sind, dass hierdurch reihenartige Bereiche von verschalteten und verschaltungsfreien Zwischenräumen zwischen diesen Photovoltaik-Zellen gebildet sind. So verlaufen die Leiterbahnen 4 der ersten, dem Betrachter zugewandten Trägerschicht 6 dabei in der Bildebene von links nach rechts, die Leiterbahnen 4 der zweiten, hinter der ersten angeordneten Trägerschicht 7 in der Bildebene von oben nach unten. Beide sind an ihren nicht dargestellten Enden gut elektrisch verbindbar, so dass die Verschaltung des Solarmoduls 2 insgesamt unproblematisch ist.

Durch die seitlich versetzte Anordnung der Photovoltaik-Zellen 3 der beiden Trägerschichten 6, 7, die sandwichartig übereinander liegen, ist an dem Solarmodul 2 aus den hier quadratischen Photovoltaik-Zellen 3 ein regelmäßiges Muster in Form eines Gittermusters gebildet, bei dem die Photovoltaik-Zellen 3 für einen Betrachter ein scheinbar zusammenhängendes, gleichwohl von Zwischenräumen durchwirktes Gebiet bilden, bei dem die Photovoltaik-Zellen 3 der beiden Schichten 6, 7 exakt aneinander angrenzen, also keine Zelle 3 andere Zellen ganz oder teilweise überdeckt.

In der Fig.2 erkennt man die erste Trägerschicht 6 mit Photovoltaik-Zellen 3 des Solarmoduls 2 der Photovoltaik-Anordnung 1. Die quadratischen Photovoltaik-Zellen 3 der Trägerschicht 6 sind an ihren einander zugewandten Seiten unmittelbar, aber mit einem vernachlässigbaren, weil nicht notwendigen Zwischenraum, der jeweils Fertigungstoleranzen ausgleichen soll, benachbart zueinander derart angeordnet, dass sie Reihen 8 von Photovoltaik-Zellen 3 bilden. Zwischen den Reihen 8 der Photovoltaik-Zellen 3 befinden sich Zwischenräume 5 und die die Zellen 3 verschaltenden Leiterbahnen 4 erstrecken sich über die Längserstreckung der Reihen 8 über die Zellen 3, so dass am Rande der Trägerschicht ein elektrischer Anschluss der Zellen 3 geschaltet werden kann.

In der Fig.3 ist die zweite Trägerschicht 7 eines Solarmoduls 2 der Photovoltaik-Anordnung 1 zu erkennen. Diese Schicht 7 weist Photovoltaik-Zellen 3 auf, die einzeln und nach allen Seiten regelmäßig zu einer benachbarten Zelle 3 beabstandet angeordnet sind, so dass zwischen den Zellen Zwischenräume 5 gebildet sind. Durch die regelmäßige Anordnung der Photovoltaik-Zellen 3 ergibt sich, unterbrochen jeweils durch die betreffenden Zwischenräume 5, wiederum reihenartige Struktur der Zellen, sowohl in für den Betrachter vertikaler wie horizontaler Richtung. Weiter deutlich zu erkennen ist in der Fig.3 die Verschaltung der Photovoltaik-Zellen 3 der zweiten Trägerschicht 7, bei welcher mehrere jeweils benachbarte Photovoltaik-Zellen 3 derart durch parallele Züge von Leiterbahnen 4 verbunden sind, dass hierdurch reihenartige Bereiche von verschalteten und verschaltungsfreien Zwischenräumen 5 zwischen diesen Photovoltaik-Zellen 3 gebildet sind. Die Zellen 3 der Fig. 3 sind untereinander nach allen Seiten mit einem Abstand zu einer jeweils benachbarten Zelle 3 versehen, der der Längenerstreckung einer quadratischen Zelle 3 der ersten Trägerschicht 6 zuzüglich dem doppelten dortigen Abstand zwischen zwei Zellen 3 einer Reihe 8 entspricht. Auf diese Weise kann durch seitlich versetzte und sandwichartige Anordnung der Photovoltaik-Zellen 3 der beiden Trägerschichten 6, 7 aus den Fig. 2 und 3 übereinander die in der Fig. 1 dargestellte Photovoltaik-Anordnung 1 mit dem bereits bekannten Gittermuster gebildet werden, und zwar so, dass die an sogenannt verschalteten Zwischenräumen 5 eigentlich sichtbaren Leiterbahnen 4 der zweiten Trägerschicht 7 gerade von den Reihen 8 von Photovoltaik-Zelle 3 der ersten Trägerschicht 6 überdeckt und damit für einen Betrachter praktisch unsichtbar sind.

In der Fig.4 ist schließlich ein Teilquerschnitt einer Photovoltaik-Anordnung 1 mit einem Solarmodul 2 dargestellt, wie sie zur Anbringung an einer Fassaden-, Fenster- oder Dachfläche vorgesehen sein kann. Die Anordnung 1 ist schichtweise aufgebaut, ihre Schichten erstrecken sich in die Betrachtungsebene. Die Photovoltaik-Anordnung 1 weist dabei für den Betrachter gesehen oben zunächst ein dem einfallenden Licht zugewandtes, lichtdurchlässiges erstes Tragelement 9 auf, hinter welchem die erste Trägerschicht 6 mit Photovoltaik-Zellen angeordnet ist. Als nächste Schicht der Anordnung 1 ist als wiederum lichtdurchlässige Trennschicht 10 ein Laminat 10 vorgesehen, welche die erste Trägerschicht 6 von der auf das Laminat 10 folgenden zweiten Trägerschicht 7 elektrisch isoliert. Auf die zweite Trägerschicht 7 folgt zuletzt ein weiteres Tragelement 11, welches mit einer größeren Dicke als das erste Tragelement 9 versehen ist. Beide Tragelemente 9, 11 sind aus Glasscheiben gebildet, das erste aus Einscheibensicherheitsglas, das zweite aus Verbundsicherheitsglas und somit lichtdurchlässig. Hierdurch ist die gesamte Photovoltaik-Anordnung 1 lichtdurchlässig, so dass zumindest ein Teil des einfallenden Lichts in dem hinter der Anordnung 1 befindlichen, nicht weiter dargestellten Raum ankommt.

Demnach betrifft die vorstehend beschriebene Erfindung also eine Photovoltaik-Anordnung 1 mit einem Solarmodul 2, welches eine Trägerschicht und darauf befindliche Photovoltaik-Zellen 3 aufweist, die über Leiterbahnen 4 elektrisch miteinander verbunden sind. Die Photovoltaik-Anordnung ist insbesondere auch als optisches Stilmittel an Fassaden-, Fenster- und/oder Dachflächen gut einsetzbar, weil das Solarmodul 2, zumindest bereichsweise, über Zwischenräume 5 beabstandete Photovoltaik-Zellen 3 aufweist, das Solarmodul 2 mehrere Trägerschichten 6, 7 mit darauf befindlichen Photovoltaik-Zellen 3 aufweist, von denen jeweils zumindest einige Zellen 3 Abstand zueinander haben, die Trägerschichten 6, 7 übereinander angeordnet und galvanisch voneinander getrennt sind und die Photovoltaik-Zellen 3 der einzelnen, übereinander befindlichen Trägerschichten 6, 7 derart gegeneinander seitlich versetzt sind, dass sie einen oder mehrere Zwischenräume 5 zwischen den Zellen 3 einer anderen Schicht 6, 7 überdecken und mehrere oder wenigstens ein Zwischenraum 5 zwischen den Zellen 3 zumindest derart teilweise überdeckungsfrei ist, dass ein Anteil des von einer Lichtquelle auf die Photovoltaik-Anordnung 1 eingestrahlten Lichts das Solarmodul 2 durchtritt.

## Patentansprüche

1. Photovoltaik-Anordnung mit einem Solarmodul, welches eine Trägerschicht und darauf befindliche PhotovoltaikZellen aufweist, die über Leiterbahnen elektrisch miteinander verbunden sind, wobei das Solarmodul, zumindest bereichsweise, über Zwischenräume beabstandete Photovoltaik-Zellen aufweist und das Solarmodul mehrere Trägerschichten mit darauf befindlichen Photovoltaik-Zellen aufweist, von denen jeweils zumindest einige Zellen Abstand zueinander haben, und wobei die Trägerschichten übereinander angeordnet und galvanisch voneinander getrennt sind, **dadurch gekennzeichnet, dass** die Photovoltaik-Zellen (3) der einzelnen, übereinander befindlichen Trägerschichten (6, 7) derart gegeneinander seitlich versetzt sind, dass sie einen oder mehrere Zwischenräume (5) zwischen den Zellen (3) einer anderen Schicht (6, 7) überdecken und mehrere oder wenigstens ein Zwischenraum (5) zwischen den Zellen (3) zumindest teilweise derart überdeckungsfrei ist, dass ein Anteil des von einer Lichtquelle auf die Photovoltaik-Anordnung (1) eingestrahlten Lichts das Solarmodul (2) durchtritt.

2. Photovoltaik-Anordnung nach Anspruch 1, **dadurch gekennzeichnet, dass** das Solarmodul (2) drei oder mehr Trägerschichten (6, 7) mit Photovoltaik-Zellen (3) aufweist.

3. Photovoltaik-Anordnung nach Anspruch 1 oder 2, **dadurch gekennzeichnet, dass** die Anordnung (1) derart vorgesehen ist, dass in Zellenzwischenräumen (5) einer Trägerschicht (6, 7) verlaufende Leiterbahnen (4) durch Photovoltaik-Zellen (3) zumindest einer weiteren Trägerschicht (6, 7) überdeckt sind.

4. Photovoltaik-Anordnung nach einem der Ansprüche 1 bis 3, **dadurch gekennzeichnet, dass** das Solarmodul (2) zwei Trägerschichten (6, 7) aufweist, von welchen die erste (6) mit zueinander beabstandeten Reihen (8), jeweils bestehend aus unmittelbar benachbarten Photovoltaik-Zellen (3), versehen ist, während die zweite Trägerschicht (7) einzelne, mit Zwischenräumen (5) beabstandete Photovoltaik-Zellen (3) aufweist.

5. Photovoltaik-Anordnung nach Anspruch 4, **dadurch gekennzeichnet, dass** die erste Trägerschicht (6) entlang der Längserstreckung ihrer Reihen (8) von Photovoltaik-Zellen (3) mit Leiterbahnen (4) verschaltet ist und dass mehrere jeweils benachbarte Photovoltaik-Zellen (3) der zweiten Trägerschicht (7) derart durch parallele Züge von Leiterbahnen (4) verbunden sind, dass hierdurch reihenartige Bereiche von verschalteten und verschaltungsfreien Zwischenräumen (5) zwischen diesen Photovoltaik-Zellen (3) gebildet sind.

6. Photovoltaik-Anordnung nach Anspruch 5, **dadurch gekennzeichnet, dass** die Photovoltaik-Zellen (3) der ersten und der zweiten Trägerschicht (6, 7) derart gegeneinander seitlich versetzt angeordnet sind, dass die verschalteten reihenartigen Bereiche der zweiten Trägerschicht (7) von Photovoltaik-Zellen (3) der ersten Trägerschicht (6) überdeckt sind.

7. Photovoltaik-Anordnung nach einem der vorhergehenden Ansprüche, **dadurch gekennzeichnet, dass** die Photovoltaik-Zellen (3) der übereinander angeordneten Trägerschichten (6, 7) des Solarmoduls (2) ein gegebenenfalls regelmäßiges Muster, insbesondere ein netz- oder schachbrettartiges Gittermuster, bilden.

8. Photovoltaik-Anordnung nach Anspruch 7, **dadurch gekennzeichnet, dass** das Muster von Photovoltaik-Zellen (3) des Solarmoduls (2) aus rechteckigen, insbesondere quadratischen, und/oder rautenförmigen Photovoltaik-Zellen (3) vorgesehen ist.

9. Photovoltaik-Anordnung nach einem der vorhergehenden Ansprüche, **dadurch gekennzeichnet, dass** alle Photovoltaik-Zellen (3) der Trägerschichten (6, 7) dieselbe Größe aufweisen.

10. Photovoltaik-Anordnung nach einem der vorhergehenden Ansprüche, **dadurch gekennzeichnet, dass** das Solarmodul (2) mit den auf Trägerschichten (6, 7) befindlichen Photovoltaik-Zellen (3) eine Lichtdurchlässigkeit in einem Bereich zwischen 10 und 90 Prozent, bevorzugt etwa zwischen 30 und 60 Prozent aufweist.

11. Photovoltaik-Anordnung nach einem der vorhergehenden Ansprüche, **dadurch gekennzeichnet, dass** in Randbereichen des Solarmoduls (2) befindliche Photovoltaik-Zellen (3) einer der Trägerschichten (6, 7), insbesondere bei nicht rechteckiger Ausbildung der Photovoltaik-Anordnung (1), entweder elektrisch inaktivierbar oder nicht verschaltet sind.

12. Photovoltaik-Anordnung nach einem der vorhergehenden Ansprüche, **dadurch gekennzeichnet, dass** das Solarmodul (2) zwischen seinen Trägerschichten (6, 7) jeweils eine lichtdurchlässige Trennschicht (10), insbesondere ein Laminat oder eine Scheibe aus Glas oder Kunststoff, aufweist, die die Trägerschichten (6, 7) gegeneinander elektrisch isoliert.

13. Photovoltaik-Anordnung nach einem der vorhergehenden Ansprüche, **dadurch gekennzeichnet, dass** das Solarmodul (2) zwischen zwei Tragelementen (9, 11) angeordnet ist, von welchen zumindest das der Lichtseite zugewandte Tragelement (9) licht- oder strahlungsdurchlässig vorgesehen ist.

14. Photovoltaik-Anordnung nach Anspruch 13, **dadurch gekennzeichnet, dass** das Solarmodul (2) durch ein Haltemittel, insbesondere ein Gießharz oder ein Laminat, zwischen den Tragelementen (9, 11) ortsfest gehalten ist.

15. Photovoltaik-Anordnung nach Anspruch 13 oder 14, **dadurch gekennzeichnet, dass** die Tragelemente (9, 11) aus Kunststoff- und/oder Glasscheiben, insbesondere aus Sicherheitsglas, vorgesehen sind.

16. Photovoltaik-Anordnung nach einem der vorhergehenden Ansprüche, **dadurch gekennzeichnet, dass** das Solarmodul (2) zum Einbau in eine Isolierverglasung vorgesehen ist.

## Claims

1. Photovoltaic arrangement having a solar module which comprises a carrier layer and photovoltaic cells disposed thereon which are electrically connected to one another by means of printed circuit board tracks, wherein the solar module comprises, at least in parts, photovoltaic cells spaced apart by interstices and the solar module comprises a plurality of carrier layers with photovoltaic cells disposed thereon, at least some of said cells being spaced apart from one another, and wherein the carrier layers are arranged above one another and are galvanically separated from one another, **characterised in that** the photovoltaic cells (3) of the individual carrier layers (6, 7) disposed above one another are laterally offset relative to one another such that they overlap one or more interstices (5) between the cells (3) of another layer (6, 7) and several or at least one interstice (5) between the cells (3) is at least partly free from overlaps such that a proportion of the light irradiated from a light source onto the photovoltaic arrangement (1) passes through the solar module (2).

2. Photovoltaic arrangement according to claim 1, **characterised in that** the solar module (2) comprises three or more carrier layers (6, 7) with photovoltaic cells (3).

3. Photovoltaic arrangement according to claim 1 or 2, **characterised in that** the arrangement (1) is provided such that printed circuit board tracks (4) running in cell interstices (5) in a carrier layer (6, 7) are overlapped by photovoltaic cells (3) of at least one other carrier layer (6, 7).

4. Photovoltaic arrangement according to one of claims 1 to 3, **characterised in that** the solar module (2) comprises two carrier layers (6, 7), the first (6) of which is provided with spaced-apart rows (8), each consisting of photovoltaic cells (3) directly adjacent to one another, while the second carrier layer (7) comprises individual photovoltaic cells (3) spaced apart by interstices (5).

5. Photovoltaic arrangement according to claim 4, **characterised in that** the first carrier layer (6) is wired up with printed circuit board tracks (4) along the longitudinal extent of its rows (8) of photovoltaic cells (3) and **in that** a plurality of adjacent photovoltaic cells (3) of the second carrier layer (7) are connected by parallel trains of printed circuit board tracks (4) in such a way that row-like areas of wired and non-wired interstices (5) are thus formed between these photovoltaic cells (3).

6. Photovoltaic arrangement according to claim 5, **characterised in that** the photovoltaic cells (3) of the first and second carrier layers (6, 7) are laterally offset from one another such that the wired-up row-like areas of the second carrier layer (7) are overlapped by photovoltaic cells (3) of the first carrier layer (6).

7. Photovoltaic arrangement according to one of the preceding claims, **characterised in that** the photovoltaic cells (3) of the carrier layers (6, 7) of the solar module (2) arranged one above the other form an optionally regular pattern, particularly a mesh-type or chequerboard-like grid pattern.

8. Photovoltaic arrangement according to claim 7, **characterised in that** the pattern of photovoltaic cells (3) of the solar module (2) is formed by rectangular, particularly square, and/or rhombic photovoltaic cells (3).

9. Photovoltaic arrangement according to one of the preceding claims, **characterised in that** all the photovoltaic cells (3) of the carrier layers (6, 7) are the same size.

10. Photovoltaic arrangement according to one of the preceding claims, **characterised in that** the solar module (2) with the photovoltaic cells (3) disposed on carrier layers (6, 7) has a transmittance in the range between 10 and 90 percent, preferably between about 30 and 60 percent.

11. Photovoltaic arrangement according to one of the preceding claims, **characterised in that** photovoltaic cells (3) of one of the carrier layers (6, 7) located in edge regions of the solar module (2), particularly if the photovoltaic arrangement (1) is not rectangular in configuration, are either electrically inactivatable or are not wired up.

12. Photovoltaic arrangement according to one of the preceding claims, **characterised in that** the solar module (2) comprises between its carrier layers (6, 7) a translucent separating layer (10), particularly a laminate or a sheet of glass or plastics which electrically insulates the carrier layers (6, 7) from one another.

13. Photovoltaic arrangement according to one of the preceding claims, **characterised in that** the solar module (2) is arranged between two carrier elements (9, 11), of which at least the carrier element (9) facing the light side is designed to be translucent or pervious to radiation.

14. Photovoltaic arrangement according to claim 13, **characterised in that** the solar module (2) is held in place between the carrier elements (9, 11) by a retaining means, particularly a casting resin or a laminate.

15. Photovoltaic arrangement according to claim 13 or 14, **characterised in that** the carrier elements (9, 11) are made of sheets of plastics and/or glass, particularly safety glass.

16. Photovoltaic arrangement according to one of the preceding claims, **characterised in that** the solar module (2) is provided for installation in insulating glazing.

## Revendications

1. Dispositif photovoltaïque, avec un module solaire qui présente une couche support et des cellules photovoltaïques qui se trouvent sur celle-ci et sont reliées électriquement entre elles au moyen de pistes conductrices, sachant que le module solaire présente au moins dans certaines zones des cellules photovoltaïques espacées par des espaces intermédiaires et que le module solaire présente plusieurs couches supports avec des cellules photovoltaïques se trouvant sur celles-ci, parmi lesquelles au moins certaines cellules sont respectivement distantes entre elles, et sachant que les couches supports sont disposées les unes au-dessus des autres et sont isolées galvaniquement les unes par rapport aux autres, **caractérisé en ce que** les cellules photovoltaïques (3) des couches supports individuelles superposées (6, 7) sont latéralement décalées les unes par rapport aux autres de telle sorte qu'elles recouvrent un ou plusieurs espaces intermédiaires (5) entre les cellules (3) d'une autre couche (6, 7), et plusieurs espaces intermédiaires (5) ou au moins un espace intermédiaire (5) entre les cellules (3) sont ou est au moins partiellement dépourvu(s) de recouvrement de telle sorte qu'une partie de la lumière irradiée par une source lumineuse sur le dispositif photovoltaïque (1) traverse le module solaire (2).

2. Dispositif photovoltaïque selon la revendication 1, **caractérisé en ce que** le module solaire (2) présente trois couches supports (6, 7) ou davantage, pourvues de cellules photovoltaïques (3).

3. Dispositif photovoltaïque selon la revendication 1 ou 2, **caractérisé en ce que** le dispositif (1) est prévu de telle sorte que les pistes conductrices (4) qui s'étendent dans les espaces intermédiaires de cellules (5) d'une couche support (6, 7) sont recouvertes par des cellules photovoltaïques (3) d'au moins une autre couche support (6, 7).

4. Dispositif photovoltaïque selon l'une des revendications 1 à 3, **caractérisé en ce que** le module solaire (2) présente deux couches supports (6, 7) parmi lesquelles la première (6) est pourvue de rangées mutuellement distantes (8) respectivement constituées de cellules photovoltaïques (3) directement voisines, tandis que la deuxième couche support (7) présente des cellules photovoltaïques (3) espacées par des espaces intermédiaires (5).

5. Dispositif photovoltaïque selon la revendication 4, **caractérisé en ce que** la première couche support (6) est connectée par des pistes conductrices (4) le long de l'étendue longitudinale de ses rangées (8) de cellules photovoltaïques (3), et **en ce que** plusieurs cellules photovoltaïques respectivement voisines (3) de la deuxième couche support (7) sont reliées par des tracés parallèles de pistes conductrices (4) de telle sorte que sont ainsi formées des zones du genre rangées d'espaces intermédiaires (5) connectés et d'espaces intermédiaires (5) dépourvus de connexion entre ces cellules photovoltaïques (3).

6. Dispositif photovoltaïque selon la revendication 5, **caractérisé en ce que** les cellules photovoltaïques (3) de la première et de la deuxième couches supports (6, 7) sont disposées en étant latéralement décalées les unes par rapport aux autres de telle sorte que les zones connectées du genre rangées de la deuxième couche support (7) sont recouvertes par des cellules photovoltaïques (3) de la première couche support (6).

7. Dispositif photovoltaïque selon l'une des revendications précédentes, **caractérisé en ce que** les cellules photovoltaïques (3) des couches supports superposées (6, 7) du module solaire (2) forment un motif éventuellement régulier, en particulier un motif de quadrillage du genre treillis ou échiquier.

8. Dispositif photovoltaïque selon la revendication 7, **caractérisé en ce que** le motif de cellules photovoltaïques (3) du module solaire (2) est constitué de cellules photovoltaïques (3) rectangulaires, en particulier carrées, et/ou en losanges.

9. Dispositif photovoltaïque selon l'une des revendications précédentes, **caractérisé en ce que** toutes les cellules photovoltaïques (3) des couches supports (6, 7) présentent la même taille.

10. Dispositif photovoltaïque selon l'une des revendications précédentes, **caractérisé en ce que** le module solaire (2) pourvu des cellules photovoltaïques (3) se trouvant sur des couches supports (6, 7) présente une perméabilité à la lumière située dans une plage comprise entre 10 et 90 pour-cent, de préférence approximativement entre 30 et 60 pour-cent.

11. Dispositif photovoltaïque selon l'une des revendications précédentes, **caractérisé en ce que** des cellules photovoltaïques (3) d'une des couches supports (6, 7) qui se trouvent dans les zones de bords du module solaire (2), en particulier en cas de configuration non rectangulaire du dispositif photovoltaïque (1), soit peuvent être électriquement désactivées, soit ne sont pas connectées.

12. Dispositif photovoltaïque selon l'une des revendications précédentes, **caractérisé en ce que** le module solaire (2) présente entre ses couches supports (6, 7) une couche séparatrice respective (10) perméable à la lumière, en particulier un stratifié ou une plaque de verre ou de matière plastique, qui isole électriquement les couches supports (6, 7) l'une par rapport à l'autre.

13. Dispositif photovoltaïque selon l'une des revendications précédentes, **caractérisé en ce que** le module solaire (2) est disposé entre deux éléments porteurs (9, 11), parmi lesquels au moins l'élément porteur (9) tourné du côté de la lumière est prévu perméable à la lumière ou au rayonnement.

14. Dispositif photovoltaïque selon la revendication 13, **caractérisé en ce que** le module solaire (2) est maintenu en position fixe entre les éléments porteurs (9, 11) par un moyen de fixation, en particulier une résine coulée ou un stratifié.

15. Dispositif photovoltaïque selon la revendication 13 ou 14, **caractérisé en ce que** les éléments porteurs (9, 11) sont constitués de plaques de matière plastique et/ou de verre, en particulier de verre de sécurité.

16. Dispositif photovoltaïque selon l'une des revendications précédentes, **caractérisé en ce que** le module solaire (2) est prévu pour être installé dans un vitrage isolant.
